Europäisches Patentamt

**European Patent Office**

**Office européen des brevets**

(11) Publication number: **0 070 691**
**B1**

(12) **EUROPEAN PATENT SPECIFICATION**

(45) Date of publication of patent specification: **30.03.88**

(21) Application number: **82303716.3**

(22) Date of filing: **15.07.82**

(51) Int. Cl.⁴: **H 01 L 23/48,** H 01 L 21/60

(54) Tape for tape-automated-bonding of integrated circuits and method of producing the tape.

(30) Priority: **17.07.81 GB 8122218**

(43) Date of publication of application:
**26.01.83 Bulletin 83/04**

(45) Publication of the grant of the patent:
**30.03.88 Bulletin 88/13**

(84) Designated Contracting States:
**AT BE CH DE FR GB IT LI NL SE**

(56) References cited:

ELECTRONICS INTERNATIONAL, vol.53, no.27,
December 1980, New York (US) J. Lyman:
"Tape automated bonding meets VLSI
challenge", pages 100-105

29TH ELECTRONIC COMPENENTS
CONFERENCE, May 14-16, 1979, Cherry Hill,
N.J. (US) S. SATO et al.: "A new approach to
reliability built-in connections for LSI
terminals", pages 94-98

(73) Proprietor: **BRITISH TELECOMMUNICATIONS
PUBLIC LIMITED COMPANY**
**81 Newgate Street**
**London EC1A 7AJ (GB)**

(72) Inventor: **Sinnadurai, Francis Nihal**
**1 Moorfield Road**
**Woodbridge Suffolk IP12 4JN (GB)**
Inventor: **Small, David John**
**Denbeigh All Saints Road Creeting St Mary**
**Ipswich Suffolk IP6 8PJ (GB)**
Inventor: **Blain, Alexander Anthony**
**41 Exeter Road**
**Felixstowe Suffolk IP11 9AJ (GB)**
Inventor: **Cooper, Kenneth**
**73 Foxglove Avenue Needham Market**
**Ipswich Suffolk IP6 8JJ (GB)**

(74) Representative: **Purell, Kevin John et al**
**British Telecom Intellectual Property Unit 13th
Floor 151 Gower Street**
**London WC1E 6BA (GB)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

(56) References cited:

BTAB - The Elusive Success; D. Brown et al.:
Proc. ISHM International Microelectronics
Symposium; New York; 1980; pp. 238-244
Bumped Tape Automated Bonding (BTAB)
Practical Application Guidelines; J.W. Kanz et
al.; IEEE Transactions on Components,
Hybrids, and Manufacturing Technology; Vol.
CHMT. 2, No. 3; September 1979; pp. 301-308.
BTAB's Future - An Optimistic Prognosis; R.F.
Unger et al.; Solid State Technology; March
1980; pp. 77-83

## Description

This invention relates to a tape for use in tape-automated-bonding of integrated circuits, and to a method of producing such a tape.

Tape-automated-bonding is a known method of making connections to the interconnection pads of integrated circuits. A length of tape (such as conventional 35 mm film base) carries a series of interconnection arrays (also known as "frames") for integrated circuits. Each array comprises a number of etched copper "beams" (also known as "leads" or "fingers"), each beam being arranged for bonding with a respective interconnection pad of an integrated circuit. The bond between each beam and interconnection pad is made via a terminal (known as a "bump") which is formed either on the interconnection pad or at a corresponding location on the beam. Re-flow soldering or thermocompression is used to form the bond. Bumps formed initially on the interconnection pads of an integrated circuit are usually provided while the integrated circuit is still part of a larger wafer, and the provision of bumps is known as "wafer bumping".

Once bonded to the tape, individual integrated circuits and their respective interconnection arrays are excised from the tape for packaging — for example, connection to a "lead frame" of a conventional dual-in-line integrated circuit package, particularly a moulded plastics package. Alternatively, the tape-bonded integrated circuits may be directly connected to a hybrid substrate or printed circuit board.

The use of tape facilitates automation of the bonding process and automatic testing of bonded chips still on the tape (if the beams are electrically isolated). For such automatic testing, the tape is loaded on a reel-to-reel transport mechanism associated with an automatic testing machine.

Tapes are available for use in tape-automated-bonding of specified integrated circuits. These tapes have interconnection arrays which are appropriate for the specified integrated circuits, the etched copper beams of the arrays each being provided with, for example, a gold-plated copper bump. Such tapes are known as "bumped tapes". Some integrated circuits are also available having interconnection pads provided with gold-plated bumps for bonding to tape. Such integrated circuits are known as "bumped chips".

With known bumped tapes, however, the bumps can fail to provide consistently satisfactory bonds. We observed that a reason for this is that the bumps of, for example, copper formed on the copper beams have relatively hard, uneven bonding surfaces which, even after gold-plating, remain uneven and unyielding, causing poor adhesion to the aluminium, or other metal, interconnection pads of the integrated circuit.

According to a first aspect of the invention as defined in independent claim 1 of the set of claims filed for the Contracting States AT, BE, CH, IT, LI, NL and SE, there is provided a tape for use in tape-automated-bonding of integrated circuits, the tape being provided along its length with a series of interconnection arrays, each array comprising a plurality of interconnection beams for bonding with interconnection pads of an integrated circuit, a terminal being provided on each interconnection beam for making a bond between that beam and a respective interconnection pad of an integrated circuit, characterised in that each terminal is formed entirely of deposited material, and in that each terminal comprises at least an outer layer of a conductive material having a Vickers hardness number of 55 or less to render the terminal compliant.

Also comprised in the state of the art by virtue of Article 54, paragraphs 3 and 4, EPC, in respect of DE, FR and GB is European Patent Application number 61863. In that document is described the production of a tape for use in bumped-tape-automated-bonding, in which the bumps are formed separate from the tape and subsequently joined to it. The bumps are formed of gold (of unspecified hardness), of tin (which inherently has a Vickers hardness of less than 55), or may be multilayered and comprise one or two gold layers with a layer of copper, nickel, silver or aluminium.

According to a second aspect of the invention as defined in independent claim 1 of the set of claims filed for the Contracting States DE, FR and GB, there is provided a tape wherein, in addition to the above defined features, the terminal has been grown on its respective interconnection beam.

Each terminal could be entirely formed by the conductive material.

The conductive material could be gold, in which case each terminal could have a core of relatively hard gold and an outer layer of relatively soft gold.

The conductive material could instead be one of a plurality of dissimilar metals which form each terminal.

According to a further aspect of the invention as defined in independent claim 6 of both sets of claims there is provided a method of producing such a tape, the method including the step of depositing a material or materials, for forming the terminals, only at locations on the tape which correspond to interconnection pads of the integrated circuit.

The material or materials could be deposited by electroplating, or, instead, a respective substantially spherical mass of the material or materials could be deposited at each of the said locations on the tape and bonded thereto.

The invention will now be described, by way of example, with reference to the accompanying drawings, in which:

Figure 1 shows a plan view of a portion of tape for tape-automated bonding, the portion including three interconnection arrays;

Figure 2 shows a detailed view of an inner corner of an interconnection array of the tape shown in Figure 1; and

Figure 3 shows a vertical, sectional view of a bond between an inner end of a beam of an interconnection array of the tape shown in Figure 1 and an interconnection pad of an integrated circuit (only part of which is shown).

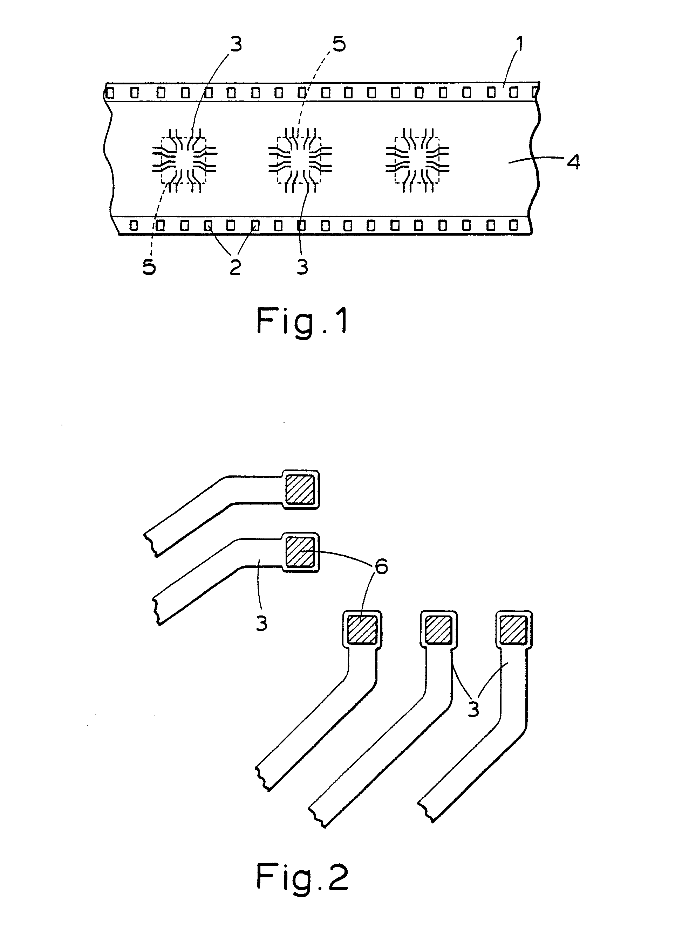

Referring to Figure 1, a tape for tape-automated-bonding comprises a flexible, insulating carrier 1 — in this case a 35 mm film base formed by a strip of polyimide which is provided with a row of perforations 2 along both of its edges. Each of the three interconnection arrays shown comprises a plurality of gold-plated copper interconnection beams 3 which have been produced by gold plating the required array pattern and then etching a copper layer (which formerly occupied a region 4 between the two rows of perforations 2). An aperture (also known as a "window") approximately 8 mm square is formed in the carrier 1 beneath each array to receive an integrated circuit to be bonded to the array. The dimensions of the windows depend on the dimensions of the integrated circuits to be bonded. These windows are indicated by the dotted lines 5 in Figure 1.

Referring to Figure 2, the inner ends of five beams 3 are shown. The innermost end of each beam 3 carries a terminal (or "bump") 6 which is made of a mass of gold having a shaped upper bonding surface for bonding with an interconnection pad of an integrated circuit.

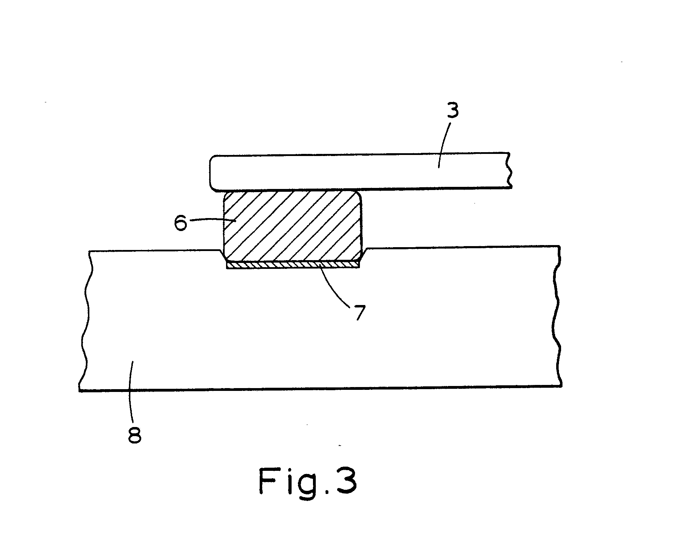

In Figure 3 a gold bump 6 at an inner end of a beam 3 is bonded to an interconnection pad 7 of an integrated circuit 8, which pad could, for example, be made of aluminium. In this case, the beam 3 (and thus the tape, which is not shown) is located above the integrated circuit 8 with its bump 6 facing downwards. Bonding of the bump 6 to the pad 7 is achieved by thermocompression.

One method of forming the bump 6 on the beams 3 (the bumps 6 and beams 3 being made of dissimilar materials) involves forming the bumps 6 separately from the beams 3 and attaching them thereto as a secondary operation. This method can be achieved by producing very small gold spheres and bonding them to the desired locations on gold-plated copper tape. Such a method is known as an "additive" method.

Another, semi-additive method involves electro-plating and is performed in the following steps.

Initially, a tape, intended for tape-automated bonding, is prepared. This tape comprises the conventional 35 mm film base 1 mentioned above, to the region 4 of which a copper layer has been fixed by adhesive. The tape is prepared by first being physically abraded. A liquid resist is applied to the windows and baked hard. The surface of the copper layer 4 is then conditioned in an acid bath.

After preparation, the tape is laminated with a 25 µm layer of negative dry-film photo-resist. A mask of the required interconnection array is next used for an exposure, and the exposed image is developed. The resulting, exposed copper beams 3 of the array are chemically cleaned and baked and then · reverse plated in concentrated orthophosphoric acid. The tape is next washed in deionised water and conditioned in a 10% orthophosphoric acid bath. The beams 3, having been prepared in this way, are now ready for electroplating with gold.

After completion of the gold-plating ("flashing") of the beams 3, the gold bumps 6 can be formed.

Firstly the remaining negative dry-film photo-resist is stripped off. The exposed copper is conditioned in an acid bath after which a 50 µm layer of negative dry-film photo-resist is applied and a mask of the required bump locations on the array is used for an exposure. The resultant exposed bump image is developed and the exposed gold flashed pads are chemically cleaned and baked. Next the bump images are conditioned in a 10% orthophosphoric acid bath which is followed by a rinse in deionised water. Finally the images are gold plated until bumps 6 having a thickness of approximately 35 µm have been built up, the walls formed in the applied photo-resist defining the shape of the bumps 6 .

The negative photo-resist is stripped off. The windows are then re-sealed with liquid resist and baked hard. Finally the unplated copper layer 4 is removed by etching in ferric chloride. Any resist remaining on the back of beams 3 is removed in an alkaline stripper.

The gold bumps 6 are particularly suited mechanically and electrically to the thermocompression bonding process used, since the soft gold used is a compliant material which has Vickers hardness number of 55 or less (typically 35) and which is more ductile than the relatively hard materials used for conventional bumps (for example, the copper commonly used has a typical Vickers hardness number of 90). Thus, the gold bumps 6 are capable of giving adhesion to integrated circuit pads which is superior to that provided by conventional bumps, the bonding achieved being substantially even over the entire bonding surfaces of the bumps. In order to provide good bonds by shearing the bonding surfaces, each bump should preferably have a rounded shape.

Each bump 6 could also be built-up by firstly depositing a core of relatively "hard" gold and secondly depositing an outer layer or relatively "soft" gold in order to provide a compliant bump. In practice, gold can have a Vickers hardness number in the range from 30 to 100 or more.

Other such compliant materials could be used in place of gold to form each, or part of each, bump. Also, bumps could be formed by the successive electro-plating of several dissimilar metals, in order to optimise the compliance and the electro-chemical characteristics of the bumps.

**Claims for the Contracting States: AT BE CH IT LI NL SE**

1. A tape for use in tape-automated-bonding of integrated circuits, the tape being provided along its length with a series of interconnection arrays, each array comprising a plurality of interconnection beams (3) for bonding with interconnection pads (7) of an integrated circuit (8), a terminal (6) being provided on each interconnection beam for making a bond between that beam and a respective interconnection pad of an integrated circuit, characterised in that each terminal is formed entirely of deposited material, and in that each terminal comprises at least an outer layer of a conductive material having a Vickers hardness number of 55 or less to render the terminal compliant.

2. A tape as claimed in claim 1, wherein each terminal is entirely formed by the conductive material.

3. A tape as claimed in claim 1 or claim 2, wherein the conductive material is gold.

4. A tape as claimed in claim 1 or claim 2, wherein each terminal comprises a core of relatively hard gold and an outer layer of relatively soft gold.

5. A tape as claimed in claim 1, or claim 3 as dependent on claim 1, wherein the conductive material is one of a plurality of dissimilar metals which form each terminal.

6. A method of producing a tape as claimed in claim 1, the method including the step of depositing the material or materials, for forming the terminals, only at locations on the tape which correspond to interconnection pads of the integrated circuit.

7. A method as claimed in claim 6, wherein the material or materials is or are deposited by electro-plating.

8. A method as claimed in claim 6 or 7, wherein gold is used as the material.

**Claims for the Contracting States: DE FR GB**

1. A tape for use in tape-automated-bonding of integrated circuits, the tape being provided along its length with a series of interconnection arrays, each array comprising a plurality of interconnection beams (3) for bonding with interconnection pads (7) of an integrated circuit (8), a terminal (6) being provided on each interconnection beam for making a bond between that beam and a respective interconnection pad of an integrated circuit, the terminals being formed entirely of deposited material, wherein each material comprises at least an outer layer of a conductive material having a Vickers hardness number of 55 or less to render the terminal compliant, the terminal having been grown on its respective interconnection beam.

2. A tape as claimed in claim 1, wherein each terminal is entirely formed by the conductive material.

3. A tape as claimed in claim 1 or claim 2, wherein the conductive material is gold.

4. A tape as claimed in claim 1 or claim 2, wherein each terminal comprises a core of relatively hard gold and an outer layer of relatively soft gold.

5. A tape as claimed in claim 1, or claim 3 as dependent on claim 1, wherein the conductive material is one of a plurality of dissimilar metals which form each terminal.

6. A method of producing a tape as claimed in claim 1, the method including the step of depositing the material or materials, for forming the terminals, only at locations on the tape which correspond to interconnection pads of the integrated circuit.

7. A method as claimed in claim 6, wherein the material or materials is or are deposited by electro-plating.

8. A method as claimed in claim 6 or 7, wherein gold is used as the material.

**Patentansprüche für die Vertragsstaaten: AT BE CH IT LI NL SE**

1. Band zur Verwendung beim Filmbonden von integrierten Schaltkreisen, wobei das Band entlang seiner Länge mit einer Serie von Verbindungsfeldern versehen ist, wobei jedes Feld ein Vielzahl von Verbindungsträgern (3) zum Verbinden mit Anschlußflächen (7) eines integrierten Schaltkreises (8) aufweist, wobei auf jedem Verbindungsträger ein Endteil (6) vorgesehen ist zur Herstellung einer Verbindung zwischen dem Träger und einer entsprechenden Anschlußfläche eines integrierten Schaltkreises, dadurch gekennzeichnet, daß jedes Endteil ganz aus abgeschiedenem Material gebildet ist, und daß jedes Endteil mindestens eine äußere Schicht aus einem leitfähigen Material aufweist, welche eine Vickers-Härtezahl von 55 oder weniger hat, um das Endteil nachgiebig zu machen.

2. Band wie in Anspruch 1 beansprucht, wobei jedes Endteil ganz aus dem leitfähigen Material gebildet ist.

3. Band wie in Anspruch 1 oder Anspruch 2 beansprucht, wobei das leitfähige Material Gold ist.

4. Band wie in Anspruch 1 oder Anspruch 2 beansprucht, wobei jedes Endteil einen Kern aus relativ hartem Gold und eine äußere Schicht aus relativ weichem Gold aufweist.

5. Band wie in Anspruch 1, oder Anspruch 3 gemäß der Abhängigkeit von Anspruch 1 beansprucht, wobei das leitfähige Material eines aus einer Vielzahl von unähnlichen Metallen ist, die jedes Endteil bilden.

6. Verfahren zur Herstellung eines Bandes wie in Anspruch 1 beansprucht, wobei das Verfahren den Schritt enthält, daß man das Material oder die Materialien zur Bildung der Endteile nur an den Orten des Bandes abscheidet, die den Anschlußflächen des integrierten Schaltkreises entsprechen.

7. Verfahren wie in Anspruch 6 beansprucht, wobei das Material oder die Materialien durch Elektroplatieren abgeschieden wird oder abgeschieden werden.

8. Verfahren wie in Anspruch 6 oder 7 beansprucht, wobei man als Material Gold verwendet.

Patentansprüche für die Vertragsstaaten: DE FR GB

1. Band zur Verwendung beim Filmbonden von integrierten Schaltkreisen, wobei das Band entlang seiner Länge mit einer Serie von Verbindungsfeldern versehen ist, wobei jedes Feld eine Vielzahl von Verbindungsträgern (3) zum Verbindun mit Anschlußflächen (7) eines integrierten Schaltkreises (8) aufweist, wobei auf jedem Verbindungsträger ein Endteil (6) vorgesehen ist zur Herstellung einer Verbindung zwischen dem Träger und einer entsprechenden Anschlußfläche eines integrierten Schaltkreises, wobei die Endteile ganz als abgeschliedenen Material gebildet sind, wobei jedes Endteil mindestens eine äußere Schicht aus einem leitfähigen Material aufweist, welches eine Vickers-Härtezahl von 55 oder weniger hat, um das Endteil nachgiebig zu machen, wobei das Endteil auf seinen entsprechenden Verbindungsträger aufgewachsen wurde.

2. Band wie in Anspruch 1 beansprucht, wobei jedes Endteil ganz aus dem leitfähigen Material gebildet ist.

3. Band wie in Anspruch 1 oder Anspruch 2 beansprucht, wobei das leitfähige Material Gold ist.

4. Band wie in Anspruch 1 oder Anspruch 2 beansprucht, wobei jedes Endteil einen Kern aus relativ hartem Gold und eine äußere Schicht aus relativ weichem Gold aufweist.

5. Band wie in Anspruch 1, oder Anspruch 3 gemäß der Abhängigkeit von Anspruch 1 beansprucht, wobei das leitfähige Material eines aus einer Vielzahl von unähnlichen Metallen ist, die jedes Endteil bilden.

6. Verfahren zur Herstellung eines Bandes wie in Anspruch 1 beansprucht, wobei das Verfahren den Schritt enthält, daß man das Material oder die Materalien zur Bildung der Endteile nur an den Orten des Bandes abscheidet, die den Anschlußflächen des integrierten Schaltkreises entsprechen.

7. Verfahren wie in Anspruch 6 beansprucht, wobei das Material oder die Materialien durch Ekeltroplatieren abgeschieden wird oder abgeschieden werden.

8. Verfahren wie in Anspruch 6 oder 7 beansprucht, wobei man als Material Gold verwendet.

Revendications pour les Etats contractants: AT BE CH IT LI NL SE

1. Une bande utilisable pour la liaison automatique par bande de circuits intégrés, la bande étant pourvue sur sa longueur d'une série de réseaux d'interconnexion, chaque réseau comprenant une pluralité de languettes d'interconnexion (3) destinées à être reliées avec des pattes d'interconnexion (7) d'un circuit intégré (8), une borne (6) étant prévue sur chaque languette d'interconnexion pour établir une liaison entre ladite languette et une patte d'interconnexion respective d'un circuit intégré, les bornes étant formées entièrement d'une matière déposée, caractérisée en ce que chaque borne comprend au moins une couche extérieure constituée d'un matériau conducteur ayant un dureté Vickers d'une valeur de 55 ou moins de manière à rendre la borne souple, la borne ayant été formée par croissance sur sa languette d'interconnexion respective.

2. Une bande telle que revendiquée dans la revendication 1, caractérisée en ce que chaque borne est entièrement formée par la matière conductrice.

3. Une bande telle que revendiquée dans la revendication 1 ou la revendication 2, caractérisée en ce que la matière conductrice est de l'or.

4. Une bande telle que revendiquée dans la revendication 1 ou la revendication 2, caractérisée en ce que chaque borne comprend un coeur en or relativement dur et une couche extérieure en or relativement mou.

5. Une bande telle que revendiquée dans la revendication 1, ou la revendication 3 dépendante de la revendication 1, caractérisée en ce que la matière conductrice est constituée par l'un d'une pluralité de métaux différents qui forment chaque borne.

6. Un procédé de fabrication d'une bande telle que revendiquée dans la revendication 1, le procédé comprenant l'étape consistant à déposer la ou les matières, destinées à former les bornes, seulement en des endroits de la bande que correspondent à des plots d'interconnexion du circuit intégré.

7. Un procédé tel que revendiqué dans la revendication 6, caractérisé en ce que la matière ou les matières est ou sont déposées par revêtement électrolytique.

8. Un procédé tel que revendiqué dans la revendication 6 ou 7, caractérisé en ce que l'or est utilisé comme ladite matière.

Revendications pour les Etats contractants: DE FR GB

1. Une bande utilisable pour la liaison automatique par bande de circuits intégrés, la bande étant pourvue sur sa longueur d'une série de réseaux d'interconnexion, chaque réseau comprenant une pluralité de languettes d'interconnexion (3) destinées à être reliées avec des pattes d'interconnexion (7) d'un circuit intégré (8), une borne (6) étant prévue sur chaque languette d'interconnexion pour établir une liaison entre ladite languette et une patte d'interconnexion respective d'un circuit intégré, caractérisée en ce que chaque bande est formée entièrement d'une matière déposée et en ce que chaque borne comprend au moins une couche extérieure d'une matière conductrice ayant une dureté Vickers d'une valeur de 55 ou moins afin de rendre la borne souple.

2. Une bande telle que revendiquée dans la revendication 1, caractérisée en ce que chaque borne est entièrement formée par la matière conductrice.

3. Une bande telle que revendiquée dans la revendication 1 ou la revendication 2, caractérisée en ce que la matière conductrice est de l'or.

4. Une bande telle que revendiquée dans la revendication 1 ou la revendication 2, caractérisée en ce que chaque borne comprend ou coeur en or relativement dur et une couche extérieur en or relativement mou.

5. Une bande telle que revendiqué dans la revendication 1, ou la revendication 3 dépendante de la revendication 1, caractérisée en ce que la matière conductrice est constituée par l'un d'une pluralité de métaux différents qui forment chaque borne.

6. Un procédé de fabrication d'une bande telle que revendiquée dans la revendication 1, le procédé comprenant l'étape consistant à déposer la ou les matières, destinées à former les bornes, seulement en des endroits de la bande qui correspondent à des plots d'interconnexion du circuit intégré.

7. Un procédé tel que revendiqué dans la revendication 6, caractérisé en ce que la matière ou les matières est ou sont déposées par revêtement électrolytique.

8. Un procédé tel que revendiqué dans la revendication 6 ou 7, caractérisé en ce que de l'or est utilisé comme ladite matière.

0 070 691

Fig.1

Fig.2

Fig.3